**Europäisches Patentamt**

**European Patent Office**

**Office européen des brevets**

(11) Publication number: **0 209 669**

**A1**

# EUROPEAN PATENT APPLICATION

(21) Application number: **86106963.1**

(22) Date of filing: **22.05.86**

(51) Int. Cl.⁴: **G 01 R 27/26**
**F 02 P 17/00**

(30) Priority: **24.05.85 ES 287056 U**

(43) Date of publication of application:
**28.01.87 Bulletin 87/5**

(84) Designated Contracting States:
**AT BE CH DE FR GB IT LI LU NL SE**

(71) Applicant: **Salvador Herrero, Manuel-Ramon**
**Barones de Alcahali, 61**
**Foyos(Valencia)(ES)**

(71) Applicant: **Albiach Perez, Olegario-Ramon**
**Barones de Alcahali, 61**
**Foyos(Valencia)(ES)**

(72) Inventor: **Salvador-Herrero, Manuel-Ramon**
**Barones de Alcahali 61**
**Foyos Valencia(ES)**

(74) Representative: **Prato, Roberto et al,**
**c/o Ingg. Carlo e Mario Torta Via Viotti 9**
**I-10121 Torino(IT)**

(54) A device for checking condensers and coils of motor vehicles.

(57) A device for checking condensers and coils of motor vehicles is described, which is divided substantially in two assembled portions, the first of which is employed to check the condition of the condensers, verifying the leakages existing in the same, while the second is used to check the ionization state of the coils having the function of transforming the battery current in high-voltage current to produce an effective spark in the sparking plugs of the engine.

EP 0 209 669 A1

"A DEVICE FOR CHECKING CONDENSERS AND COILS OF MOTOR
VEHICLES"

This invention, as stated in the enunciation
of the description, relates to a device for checking
condensers and coils in motor vehicles.

The object of the invention is to introduce
into the market an electric device with a special arrangement of its circuits, which is substantially
divided in two assembled portions, the first of which
is employed to check the condition of the condensers,
verifying the leakages existing in the same, while
the second is used to check the ionization state of
the coils having the function of transforming the battery current in high-voltage current to produce an
effective spark in the sparking plugs of the engine.

To this end, the leakage checking circuit used to check the condensers, is characterized in that it comprises a socket for the 220 V alternating current in the positive pole of which a switch has been arranged and then a resistor, extending in two derivations into which corresponding condensers are connected in parallel to increase the capacity of the circuit, needed to transform the alternating current in direct current during its passage through the rectifier diodes that are arranged in continuation.

The current goes from one of the condensers to an outlet branching to a contactor through one of the poles to be checked, while the same conductor extends and passes through one of said rectifiers, continuing to connect with the negative pole of the socket and to go through the second rectifier diode, adding to the outlet of the second condenser and exiting as rectified direct current by a branch till the other contactor which is connected to the other pole of the condenser to be checked, in this outlet pole a 220 V neon lamp being arranged.

All this is arranged in such a way that when the checking of the vehicle condenser is carried out, the same is charged with current till its full capacity and no current shall pass through it.

Each time that the neon lamp lights, this means a leakage from the checked condenser, being al-

0209669

lowed three leakages per minute to know that the condenser can be employed.

On the other hand the checking circuit for the condensers comprises a short-circuited connection, actuated by means of a push button and apt to discharge the system and the checked condenser, and through the actuation of which the switch of the socket in the circuit will be opened.

The second portion of the circuit, that will be identified as controlled derivation circuit, is employed to verify the condition of the coils of the vehicles and is characterized in that in the outlet positive pole directly connectable with the coils, it comprises a wound potentiometer with a derivation to a revolution indicator and the othe derivation to the short-circuit push-button, whose outlet conductor is grounded to the vehicle, and further from the revolution indicator exit two couplings, one for the positive terminal of the battery and the second for the negative one.

All this is arranged in such a way that the checking is carried out starting the engine stabilizing its running to the optimum rpm and passing the sliding contact of the potentiometer point by point, from minus to plus, causing in each point, by means of the push-button, a short-circuit that in turn tends to cause the reduction of the revolutions of the engine against the performance of the coil, so that the ionization tension of the latter is measured to supply the ignition circuit of the engine and the reserve capacity it contains.

In order to assist the understanding of the idea set forth, the present description is accompanied, as an integrating part of the same, by a plan in which the object of the invention has been illustrated, being it intended that the diagramatic illustrationshould not represent a limitation of the specific features of the present application.

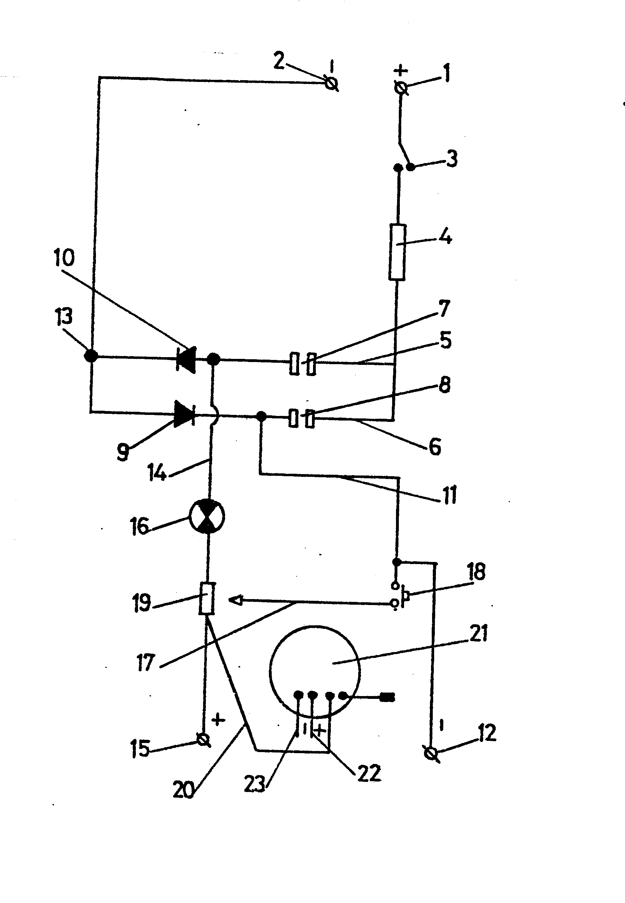

The sole figure represents a diagram of the checking circuit for condensers and coils. In this it can be noted that the circuit is divided in two portions, the first portion acting as a leakage verifier of the condenser of the vehicle, while the second portion of the circuit is the controlled derivation to check the condition of the coil of the vehicle.

The leakage checking device due to verify the condition of the condensers of the vehicle, comprises a 220 V socket having a positive pole (1) and a negative pole (2):

4.

In the positive pole a switch (3) has been arranged and in continuation a resistor (4).

The circuit comprises two derivations (5) and (6), in which two condenser in parallel (7) and (8) have been provided, in order to increase the capacity of the circuit.

This increase of the circuit capacity is necessary to transform the alternating current in direct current during its passage through the rectifier diodes (9) and (10) which are connected as a continuation.

All this is arranged in such a way that the current goes from the condenser (8) to a derivation (11) with exit to a contactor (12) at one of the poles of the condenser of the vehicle to be checked.

The same conductor of the derivation (6) extends and goes through said rectifier (9) till it connects to the negative pole (13) of the socket and goes through the second diode (10) adding to the outlet of the second condenser (7) and exiting as a rectified direct current through a derivation (14) till the other contactor (15) which is connected to the other pole of the condenser to be checked.

To this exit pole a 220 V neon lamp (16) is connected, which signals the leakages existing in the checked condenser.

What happens is that during the checking of the vehicle condenser, this is charged by the current as much as allowed by its capacity and no current shall pass through it.

When there is a leakage in the checked condenser, the neon lamp will signal it, only three leakages per minute being allowed to show that the checked condenser is in a good condition for its use.

On the other hand, the checking circuit for the condensers comprises a short-circuited connection (17) actuated by means of a push-button (18).

Actuating the push-button of the short-circuited connection, the discharge of the system and of the checked condenser will be produced, but previously by the same the supply switch (3) of the circuit will be opened.

The second portion of the circuit or controlled derivation circuit, is employed to check the coils of the vehicles.

To this end the exit positive pole of the circuit (15) is connected to the coil of the vehicle directly and to this pole a wound potentiometer (19) is connected, which is only a resistore adjustable as desired.

Said potentiometer presents a derivation (20)
to a revolution indicator (21) and another derivation
which pertains to the short-circuits (17) actuatable
by the push-button (18), whose connection or exit pole (12) is grounded to the vehicle.

Two couplings (22) and (23), respectively,
exit from the revolution indicator (21), for the connection with the positive and negative terminals of
the vehicle battery.

All this is arranged in such a way that the
check of the vehicle coil is carried out starting the
engine, which stabilizes to an optimum rpm.

When the speed of the engine is stabilized,
the potentiometer (19) is actuated displacing its
sliding contact from minus to plus, causing in every
point a short-circuit by means of the push-button
(18).

Said short-circuit tends in turn to cause a
redution of the revolutions of the engine, against the
performance of the coil, so that the ionization tension of the same is measured, which will state if it
is in a good condition, in order to transform the battery current in high voltage current to produce an
effective spark in the sparking plugs of the engine.

Having described the present invention, it must be noted that the details of the invention can be modified, that is they are subject to minor variations always based on the essential principles of this invention, which substantially are those stated in the paragraphs of the above description.

9

0209669

<u>C L A I M S</u>

<u>1</u>.    A device for checking condensers and
coils in motor vehicles, characterized in that it comprises a circuit, divided in two assembled portions,
the first of which, that will be indicated as leakage
verifier, is employed to check the condersers, and comprises a 220 V alternating current socket in the positive pole of which a switch has been arranged and
in continuation a resistor extending in two derivations to which two corresponding condensers are connected, that are placed in parallel in order to increase the circuit capacity, necessary to transform
the alternating current in direct current in the passage through the rectifier diodes arranged in the prosecution, going the current from one of the condensers to a derivation with exit to a contactor through
one of the poles of the condenser to be checked, while
the same conductor extends and passes through one of
the rectifier diodes and continues to connect to the
negative pole of the socket and to pass through the
second rectifier diode adding to the exit of the second condenser and exiting as a rectified direct current through a derivation till the other contactor
that connects to the other pole of the condenser to
be checked, to this exit pole a 220 V neon lamp being connected and next a short-circuited connection, actuatable by means of a push-button, to discharge the
system and the checked condenser, before the actuation
of the push-button placing in the open position the
switch of the socket.

2. A device for checking condensers and
coils in motor vehicles as claimed in the preceding
claim, characterized in that the second portion of
the circuit, that will be indicated as controlle derivation circuit and is employed to check the coils,
comprises, arranged in the exit positive pole direct-
ly connectable with the coil, a wound potentiometer
with a derivation to a revolution indicator and another derivation to the short-circuit push-button, the
exit conductor of which is grounded to the vehicle,
from the revolution indicator two couplings exiting,
one for the positive terminal of the battery and the
other for the negative one, carrying out the check
starting the engine, stabilizing its running at an
optimum rpm and displacing the sliding contact of
the potentiometer from one point to another, from minus to plus, causing in each point by means of the
push-button a short-circuit that in turn tends to
cause the reduction of the revolutions of the engine,
against the performance of the coil, so that the ionization tension of the same is measured to supply the ignition circuit of the engine, and the reserve

capacity it contains.

0209669

**European Patent Office**

**EUROPEAN SEARCH REPORT**

## DOCUMENTS CONSIDERED TO BE RELEVANT

EP 86106963.1

| Category | Citation of document with indication, where appropriate, of relevant passages | Relevant to claim | CLASSIFICATION OF THE APPLICATION (Int Cl 4) |
|---|---|---|---|
| A | DE - A1 - 2 557 449 (UNITED TECHNOLOGIES CORP.) <br> * Claim 1 * <br> ———— | 1 | G 01 R 27/26 <br> F 02 P 17/00 |

**TECHNICAL FIELDS SEARCHED (Int Cl 4)**

F 02 P 17/00
G 01 R 27/00

The present search report has been drawn up for all claims

| Place of search | Date of completion of the search | Examiner |
|---|---|---|
| VIENNA | 07-11-1986 | KUNZE |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82